Europäisches Patentamt

**European Patent Office**

Office européen des brevets

(19)

(11) Numéro de publication: **0 272 969 B1**

(12) **FASCICULE DE BREVET EUROPEEN**

(45) Date de publication de fascicule du brevet: **20.05.92**   (51) Int. Cl.⁵: **H03M 7/00**

(21) Numéro de dépôt: **87402737.8**

(22) Date de dépôt: **02.12.87**

(54) **Procédé et appareil programmable pour le transcodage de chaînes de caractères.**

(30) Priorité: **23.12.86 FR 8618099**

(43) Date de publication de la demande:
**29.06.88 Bulletin 88/26**

(45) Mention de la délivrance du brevet:
**20.05.92 Bulletin 92/21**

(84) Etats contractants désignés:
**DE GB**

(56) Documents cités:
**EP-A- 0 196 191
US-A- 3 082 406
US-A- 4 425 626**

**IBM TECHNICAL DISCLOSURE BULLETIN, vol.
19, no. 6, novembre 1976, pages 1963-1964,
New York, US; J.L. GAUDET et al.: "Code
translation algorithm"**

(73) Titulaire: **Valero, Robert
10, Allée des Epines
F-78180 Montigny-le-Bretonneux(FR)**

Titulaire: **Mounier, Jean-Pierre
2, rue des Favorites
F-75015 Paris(FR)**

Titulaire: **Berruyer, Yves
94 Boulevard Gabriel Péri
F-92240 Malakoff(FR)**

(72) Inventeur: **Valero, Robert
10, Allée des Epines
F-78180 Montigny-le-Bretonneux(FR)**
Inventeur: **Mounier, Jean-Pierre
2, rue des Favorites
F-75015 Paris(FR)**
Inventeur: **Berruyer, Yves
94 Boulevard Gabriel Péri
F-92240 Malakoff(FR)**

(74) Mandataire: **Cabinet Martinet & Lapoux
BP 405
F-78055 Saint Quentin en Yvelines
Cédex(FR)**

## Description

La présente invention concerne un procédé et un appareil programmable pour le transcodage de chaînes de caractères et d'une manière générale, des problèmes d'incompatibilité de codage de caractères et de messages d'instruction pouvant se poser entre deux systèmes différents de traitement de données lorsque ceux-ci doivent communiquer entre eux. Par exemple, l'un des systèmes est un micro-ordinateur ou un terminal connaissant un alphabet de caractères et une structure de message donnés, et l'autre système est un système électronique central connaissant des alphabet et structure de message différents.

Il existe actuellement un large éventail de terminaux, de micro-ordinateurs, et de systèmes électroniques n'utilisant pas toujours le même alphabet de caractères, le même protocole d'échanges en transmission et réception, ou la même structure de message. Cette incompatibilité entre ces différents matériels rend souvent impossible leurs interconnexions pour la réalisation d'équipements ou de systèmes plus évolués.

Des matériels devant être par nature compatibles et adaptables sont bien souvent, en fait, incompatibles, tels que les terminaux équipés pour la plupart d'un clavier ayant des touches déterminant des fonctions-programmes auxquelles sont attribuées des combinaisons de codage fixées arbitrairement par le constructeur. Certains terminaux font appel à des codes d'ordres spécifiques, respectivement pour leur gestion interne et une gestion de périphériques qui leurs sont raccordés. De tels terminaux raccordés à un système électronique central ne connaissant pas les mêmes codes d'ordres présentent un fonctionnement incomplet. De plus, l'évolution constante des techniques informatiques contribue à l'apparition de différents types de terminaux, notamment des terminaux à visualisation en couleurs, rendant plus délicat les problèmes d'incompatibilité.

La normalisation existante permet de disposer de protocoles d'échanges normalisés, tels que l'ANSI, le VT52, le VT100, ou le standard vidéotex. Ces protocoles ont l'avantage de rendre adaptables les matériels pour certains types d'échanges mais réduisent bien souvent le champ d'utilisation de matériels plus performants.

Par ailleurs, la gamme des alphabets normalisés existants est en perpétuelle évolution pour répondre aux différents besoins nationaux et s'adapter aux nouvelles possibilités technologiques. Ainsi à un même caractère peut correspondre des combinaisons binaires de codage différentes suivant l'alphabet normalisé qui est utilisé.

La présente invention vise à fournir un procédé et des appareils de transcodage pour résoudre les problèmes d'incompatibilité évoqués ci-dessus.

A cette fin, le procédé selon l'invention est tel que défini dans la revendication 1.

Selon le procédé de l'invention, un message à transcoder transmis par un premier système numérique de traitement de données vers un second système numérique de traitement de données peut être composé d'un ou plusieurs mots binaires représentant respectivement, dans un premier alphabet associé audit premier système, un caractère ou une chaîne de caractères auxquels correspondent généralement une entité déterminée ou une signification déterminée. Le message à transcoder transmis peut ne pas avoir d'équivalent ou de signification pour le second système, auquel cas aucun message ne sera délivré au second système. Au message à transcoder transmis peut correspondre un ou plusieurs mots binaires représentant respectivement dans un second alphabet associé au second système, un caractère ou une chaîne de caractères.

Un appareil de transcodage pour la mise en oeuvre du procédé selon l'invention est tel que défini dans la revendication 4.

L'invention vise également à fournir des appareils de transcodage programmables afin qu'un même appareil soit adaptable et utilisable pour résoudre différents types d'incompatibilité de codage.

A cette fin, un appareil programmable de transcodage selon l'invention comprend des moyens pour initialiser des moyens de traitement lors d'une phase préalable au transcodage, par le chargement dans une mémoire vive desdits moyens de traitement de tables de transcodage et d'autres tables dont une ou des tables de messages transcodés.

Le procédé selon l'invention présente les principaux avantages suivants :
- il n'est pas nécessaire que les chaînes de caractères à transcoder comprennent des "caractères délimiteurs" signalant le début et la fin de la chaîne.
- le temps de traitement du transcodage est négligeable. En effet, du fait de l'utilisation de tables de transcodage contenant des valeurs précalculées, les opérations de transcodage sont simples et se résument à des décalages, des comparaisons, et des lectures et écritures dans les tables. Cette simplicité des opérations de transcodage résultent également d'un traitement en mode caractère, c'est-à-dire chaque caractère introduit dans l'appareil de transcodage fait progresser le traitement d'un pas, contrairement au traitement en mode bloc de caractères ;

- l'utilisation de modes d'adressage relatif ou indexé contribue à optimiser l'espace mémoire nécessaire au traitement, ce qui rend dans la plupart des cas l'utilisation d'un microprocesseur à 8 bits possible ;
- il est possible d'identifier des caractères ou des chaînes de caractères imbriqués dans des chaînes de caractères de tailles supérieures ; et
- l'augmentation des performances, quant à la quantité des caractères, ou de chaînes de caractères, différents transcodables par un appareil de transcodage selon l'invention dépend uniquement de l'espace mémoire disponible dans ledit appareil de transcodage.

Les deux derniers avantages cités permettant, en outre, d'envisager l'utilisation de l'invention à des fins cryptographiques.

D'autres avantages et caractéristiques de l'invention apparaîtront plus clairement à la lecture de la description suivante de plusieurs réalisations de l'invention en référence aux dessins annexés correspondants dans lesquels :

- la Fig.1 est un bloc-diagramme fonctionnel d'un appareil programmable de transcodage unidirectionnel selon l'invention ;
- la Fig.2 montre une organisation simplifiée de tables de transcodage incluses dans un appareil de transcodage pour la mise en oeuvre du procédé selon l'invention ;
- la Fig.3 montre l'utilisation d'une table d'index pour réduire la taille des tables de transcodage utilisées pour l'identification de messages ; et
- la Fig.4 montre une variante préférée de l'organisation de tables de transcodage mémorisant les messages transcodés.

Dans la description de la structure et du fonctionnement d'un appareil programmable de transcodage unidirectionnel AT suivant l'invention, on considère, à titre d'exemple, un transcodage unidirectionnel à réaliser entre un premier système numérique de traitement de données S1 transmettant des messages et un second système numérique de traitement de données S2 en attente de ces messages. A partir d'un appareil de transcodage unidirectionnel, l'homme du métier peut réaliser un appareil de transcodage bidirectionnel, en doublant des tables de transcodage et en assurant un traitement en temps partagé pour les deux sens de transmission et le contrôle de flux global de l'appareil.

Les premier et second systèmes S1 et S2 utilisent respectivement des premier et second alphabets composés de caractères éditables pour la plupart et de commandes auxquels correspondent des mots binaires ayant un nombre de bits B déterminé, toutes les combinaisons binaires possibles de B bits pouvant être utilisées par les premier et second alphabets.

Les commandes sont, par exemple, des commandes utilitaires telles, que "action du buzzer", "retour chariot", et "saut de ligne" notées respectivement "BEL", "CR", et "LF" dans la plupart des alphabets normalisés existants. Par la suite dans la description le terme de caractère est utilisé, comme il est d'usage, indifféremment pour un caractère éditable ou pour une commande.

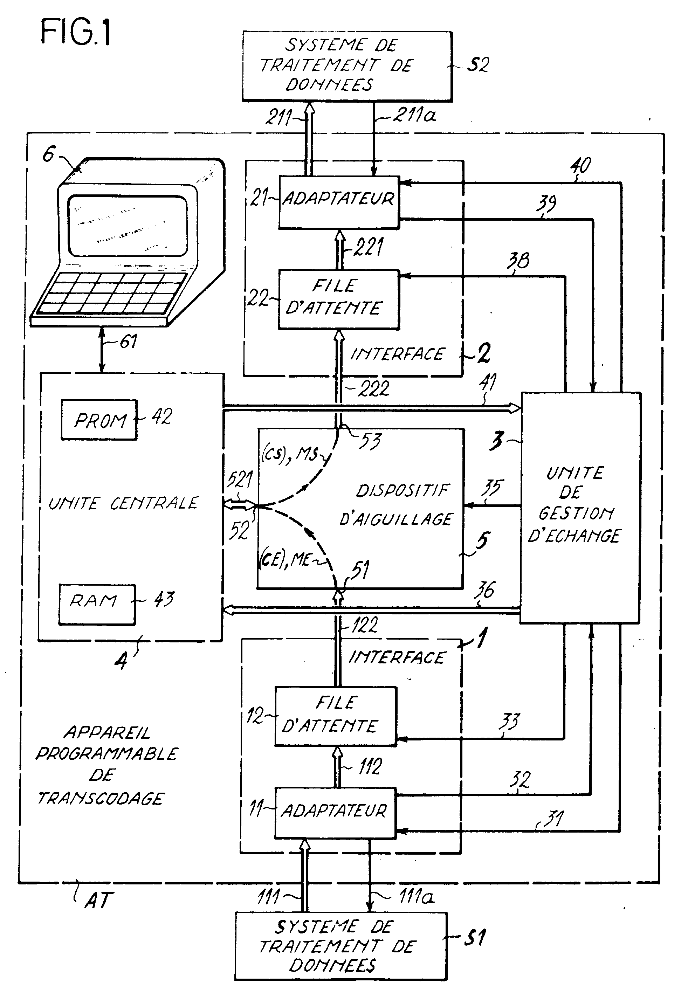

En référence à la Fig.1, le système S1 transmet à l'appareil programmable de transcodage AT des messages entrants ME à travers une liaison de transmission de données unidirectionnelles 111. Un message entrant est constitué d'un unique mot entrant (CE) ou d'une suite de N mots binaires entrants $[(CE_1), (CE_2),... (CE_n),... (CE_N)]$, N étant un entier variable pouvant varier de 1 à un nombre entier maximum prédéterminé Nmax et représentant la longueur du message entrant. A chacun des mots entrants d'une suite de mots correspond un rang n, n étant un entier compris entre 1 et N, représentatif de son ordre chronologique d'arrivée dans l'appareil de transcodage AT par rapport au premier mot reconnu $(CE_1)$ de la suite entrante. Aux mots entrants (CE) et $(CE_1)$, $(CE_2),... (CE_n),...$ $(CE_N)$ correspondent dans l'alphabet du système S1 des caractères CE et $CE_1$, $CE_2,... CE_n,... CE_N$ respectivement.

Chaque mot entrant est reçu dans l'appareil de transcodage AT par une interface d'entrée 1 via la liaison de transmission 111. Une liaison de dialogue 111a est prévue entre le système S1 et l'interface 1 afin que celle-ci puisse inviter le système S1, en cas de nécessité, à suspendre la transmission. Cette liaison de dialogue 111a peut être supprimée par l'utilisation de caractères de commande, lesquels peuvent être des caractères, "XON" et "XOFF", pour autoriser et suspendre la transmission respectivement. Les caractères de commande, "XON" et "XOFF", sont alors transmis au système S1 via la liaison de transmission 111, qui dans ce cas est bidirectionnelle.

L'interface 1 comprend un adaptateur d'entrée 11 et une file d'attente 12. L'adaptateur d'entrée 11 sert à adapter la liaison de transmission de données 111, qui peut être de type série ou de type parallèle, à des bus internes de l'appareil de transcodage AT. Par exemple, dans le cas d'une liaison de transmission 111 de type série, l'adaptateur 111 peut être un circuit spécialisé pour ce type de transmission, tel qu'un UART (Universal Asynchronous Receiver Transmitter), ou plus simplement un registre série-parallèle ; dans le cas d'une liaison de transmission 111 parallèle, des mémoires tampons d'entrée, dites "buffers", peuvent convenir.

La file d'attente 12 reçoit les mots entrants délivrés par l'adaptateur 11 en format parallèle à travers un bus 112. La file d'attente 12 est un registre de stockage de type FIFO (First in, First out).

Pour chaque mot entrant (CE) reçu, l'adaptateur 11 délivre à travers une liaison 32 un signal de détection de mot vers une unité de gestion d'échange 3. Le mot entrant (CE) est ensuite présenté en sortie sur le bus 112 relié à l'entrée de la file d'attente 12. L'unité de gestion 3 étant avisée de l'arrivée d'un mot à travers la liaison 32, un signal de commande de stockage est appliqué à la file d'attente 12, par une liaison 33, pour mémoriser dans la file 12 le mot entrant (CE) présent dans le bus 112.

Des moyens de traitement et de commande sont inclus dans l'appareil de transcodage AT sous la forme d'une unité centrale 4. L'unité 4 contient une mémoire morte 42 du type PROM contenant des micro-instructions pour exécuter un algorithme de transcodage et pour commander l'unité de gestion d'échange 3. L'unité centrale 4 délivre des mots de commande à l'unité de gestion 3 par un bus de commande 41. L'unité centrale 4 est constamment informée de l'état de l'appareil de transcodage par un mot d'état délivré par l'unité de gestion d'échange 3 dans un bus d'état 36. L'unité centrale 4 étant prête à lire un mot entrant (CE) stocké dans la file d'attente 12, afin de procéder à un traitement de transcodage, elle transmet à destination de l'unité de gestion d'échange 3 un mot de commande par le bus de commande 41. L'unité de gestion 3 décode ce mot de commande, génère un signal par la liaison 33 pour signifier à la file d'attente 12 de présenter sur un bus de sortie 122 connecté à une entrée 51 d'un dispositif d'aiguillage 5, le premier mot entrant (CE) par ordre chronologique d'arrivée. Le mot (CE) étant présent dans le bus 122, l'unité de gestion fournit alors, au dispositif d'aiguillage 5, un signal par une liaison 35, pour commander la connexion de l'entrée 51 sur une entrée/sortie 52 du dispositif d'aiguillage 5. L'entrée/sortie 52 est reliée à l'unité centrale 4 par un bus de données 521. L'unité centrale 4 lit le mot entrant (CE) présenté sur le bus 521.

Le mot entrant (CE) est identifié dans l'unité centrale 4 à l'aide de tables de transcodage contenues dans une mémoire vive 43 du type RAM.

Le mot entrant (CE) peut être identifié comme n'ayant pas de message sortant transcodé correspondant, anquel cas, il n'est pas pris en compte. L'unité centrale 4 commande alors la lecture du mot entrant suivant dans la file d'attente 12 de la manière qui vient d'être décrite, en transmettant un mot de commande à l'unité de gestion d'échange 3 par le bus 41.

Le mot entrant (CE) peut être identifié comme étant le premier mot $(CE_1)$ d'une suite de N mots entrants connue par l'unité centrale 4. L'unité centrale 4 procède alors, à la lecture et à l'identification des mots suivants de la suite entrante.

Au mot entrant (CE) ou à la suite de N mots entrants $[(CE_1), (CE_2),... (CE_n),... (CE_N)]$ constituant un message entrant ME peut correspondre un message sortant transcodé MS composé d'un mot sortant (CS) ou d'une suite de M mots sortants transcodés $[(CS_1), (CS_2),... (CS_m), ...(CS_M)]$ où m est entier compris entre 1 et M, et M est un entier variable, en général différent de l'entier N, pouvant varier de 0 à un nombre maximum prédéterminé Mmax et représentant la longueur du message sortant MS.

Dans le cas où, au message entrant ME constitué du mot entrant (CE) ou de la suite de N mots entrants correspond un message sortant transcodé MS, l'unité centrale 4 fournit à l'unité de gestion d'échange 3 un autre mot de commande par le bus 41 afin de commander l'aiguillage de chacun des mots sortants du message MS vers une interface de sortie 2 transmettant des mots sortants transcodés (CS), par une liaison de transmission 211, vers le second système S2. A la réception du mot de commande, l'unité de gestion 3 provoque la connexion de l'entrée/sortie 52 du dispositif d'aiguillage 5 avec une sortie 53 du même dispositif 5, par activation de la liaison de commande 35. La sortie 53 est reliée par un bus 222 à l'entrée d'une file d'attente 22, analogue à la file d'attente 12, incluse dans l'interface de sortie 2. Chacun des mots sortants transféré est stocké, en réponse à un signal de commande délivré par l'unité de gestion 3 via une liaison de commande 38, dans la file d'attente 22, avec des mots sortants transcodés à transmettre vers le système S2.

L'interface de sortie 2 comprend, outre la file d'attente 22, un adaptateur de sortie 21 connecté en sortie au second système S2 par la liaison de transmission 211 et une liaison de dialogue 211a. La liaison 211a peut, de même, que la liaison de dialogue 111a, être supprimée par l'utilisation des caractères de commande déjà cités "XON" et "XOFF". L'adaptateur 21 a pour fonction, de même que l'adaptateur d'entrée 11, d'adapter les bus internes de l'appareil de transcodage à la liaison de transmission unidirectionnelle 211, qui peut être, de même que la liaison 111, de type série ou parallèle.

Un bus de liaison 221 fournit des mots sortants transcodés issus de la file d'attente 22 en entrée de l'adaptateur 21. Lorsque l'adaptateur 21 est prêt à transmettre un mot sortant (CS) stocké dans la file d'attente 22, il le signale à l'unité de gestion d'échange 3 par une liaison 39. L'unité de gestion 3 ordonne alors, par la liaison 38, à la file d'attente 22 de présenter en sortie sur le bus 221 un mot sortant (CS). Le mot sortant (CS) est lu par l'adaptateur 21 qui le transmet via la liaison 211 au système S2.

L'unité de gestion d'échange 3 effectue la gestion et le contrôle des signaux échangés entre les différents circuits de l'appareil de transcodage ainsi qu'entre l'appareil de transcodage et les systèmes S1 et S2. L'unité de gestion 3 reçoit de l'unité centrale 4 un mot de commande relatif aux échanges de données à l'intérieur de l'appareil de transcodage à partir duquel sont créés différents signaux de commande envoyés aux interfaces 1 et 2 par les liaisons 31, 33, 38, et 40, ainsi qu'au dispositif d'aiguillage 5 par la liaison 35. Un mot d'état est fourni par l'unité de gestion d'échange 3 à l'unité centrale 4, à travers le bus 36 pour l'informer de tout changement intervenant dans la communication avec le système S1 ou S2.

Dans l'unité de gestion d'échange 3 sont prévus d'une manière connue, deux compteurs d'écriture et de lecture et un comparateur associés à chacune des deux files d'attente afin de déterminer le niveau de remplissage respectif de chacune des files et de comparer lesdits niveaux à des seuils de remplissage haut et bas définis de manière à réguler les débits, d'une part entre le système S1 et l'appareil de transcodage AT et d'autre part entre l'appareil de transcodage AT et le système S2, qui, en général, sont différents.

Les seuils haut et bas permettent, pour chacune des files d'attente, de gérer un contrôle de flux en fonction d'un cycle d'hystérésis destiné à éviter une dégradation des performances de l'appareil lors d'oscillation autour d'un seuil unique de remplissage. Ainsi, lorsqu' une file d'attente, 12 ou 22, atteint un niveau de remplissage au moins égal au seuil haut, une détection est faite par le comparateur associé et l'unité de gestion d'échange 3 suspend le remplissage de la file concernée par arrêt de la transmission et de l'écriture de mots dans la file. L'unité de gestion d'échange 3 autorise à nouveau l'écriture de mots dans la file d'attente, lorsque le niveau de remplissage de la file d'attente devient inférieur ou égal au seuil bas. La gestion des cycles d'hystérésis par l'unité de gestion d'échange 3 est réalisée à l'aide de deux indicateurs de remplissage, un pour chacune des files d'attente, inclus dans l'unité de gestion d'échange. Un indicateur de remplissage l'une file d'attente peut prendre deux états, un état "suspension de remplissage" et un état "fonctionnement normal". Un indicateur vient à l'état "suspension de remplissage" lorsque l'unité de gestion d'échange 3 détecte un niveau de remplissage égal ou supérieur au seuil haut pour la file d'attente correspondante. Un indicateur vient à l'état "fonctionnement normal" lorsque l'unité de gestion d'échange 3 détecte un niveau de remplissage égal ou inférieur au seuil bas de la file d'attente correspondante.

Un dépassement du seuil haut dans la file d'attente 22 provoque la transmission d'un mot d'état à destination de l'unité centrale 4, via le bus d'état 36. L'unité 4 suspend alors des écritures de mots sortants dans la file d'attente 22 et toute demande de lecture, via le bus 41, de mot contenu dans la file d'attente 12. Un dépassement de seuil haut dans la file d'attente 12 entraîne une activation de la liaison 111a vers le système S1 de manière à arrêter la transmission de mots entrants. A cet effet, l'unité de gestion d'échange 3 est reliée à l'adaptateur 11, par la liaison de commande 31.

Un niveau de remplissage de la file d'attente 22 inférieur ou égal au seuil bas provoque, si l'indicateur de remplissage associé à la file d'attente 22 était positionné à l'état "suspension de remplissage", la transmission d'un mot d'état à destination de l'unité centrale 4, via le bus d'état 36. L'unité 4 reprend alors l'écriture de mots sortants dans la file d'attente 22 et les demandes de lecture de la file d'attente 12.

Un niveau de remplissage de la file d'attente 12 inférieur ou égal au seuil bas provoque, si l'indicateur de remplissage associé à la file d'attente 12 était positionné à l'état "suspension du remplissage", la transmission d'une commande sur la liaison 31 destinée à désactiver la liaison 111a.

La liaison 211a entre le système S2 et l'adaptateur 21 est prévue afin que le système S2 demande de suspendre, c'est-à-dire d'arrêter ou de différer, une transmission de mots sortants, par exemple, à la suite d' une défaillance ou d 'un remplissage de mémoires tampons dans le système S2. La demande de suspension est transmise par l'adaptateur 21 à l'unité de gestion d' échange 3, qui la valide en délivrant à l'adaptateur 21, via la liaison 40, une commande d'arrêt de transmission vers le système S2. L'appareil de transcodage continue à opérer avec le système S1 jusqu'à un éventuel arrêt causé par un dépassement de seuil haut dans la file d'attente 12.

Lorsque la demande de suspension disparaît sur la liaison 211a, l'adaptateur 21 en informe l'unité 3, qui prend en compte ce nouvel état et délivre à l'adaptateur 21, via liaison 40, une autorisation de transmission vers le système S2.

Le fonctionnement des moyens relatifs au contrôle des flux décrit dans les paragraphes précédents correspond à une transmission unidirectionnelle sans mode écho. Dans le cas d'une transmission plus complexe les mécanismes nécessaires au contrôle des flux sont plus développés, toutefois la gestion d'hystérésis ainsi que les différents moyens décrits sont conservés.

Les tables de transcodage sont téléchargées en mémoire vive 43 dans l'unité centrale 4 lors d'une phase préalable d'initialisation, antérieurement à la mise en opération de l'appareil de transcodage. A cet effet, une liaison 61 est prévue entre l'unité centrale 4 et un micro-ordinateur 6 ayant servi à l'élaboration des tables à partir d'une analyse des alphabets de caractères des système S1 et S2, des différentes possibilités de communication entre le système S1 et le système S2, ainsi que des éventuels conflits pouvant survenir entre les deux systèmes. Le micro-ordinateur peut, en outre, servir à la visualisation de données transmises par l'unité centrale 4 pendant les opérations de transcodage, susceptibles d'intéresser un opérateur.

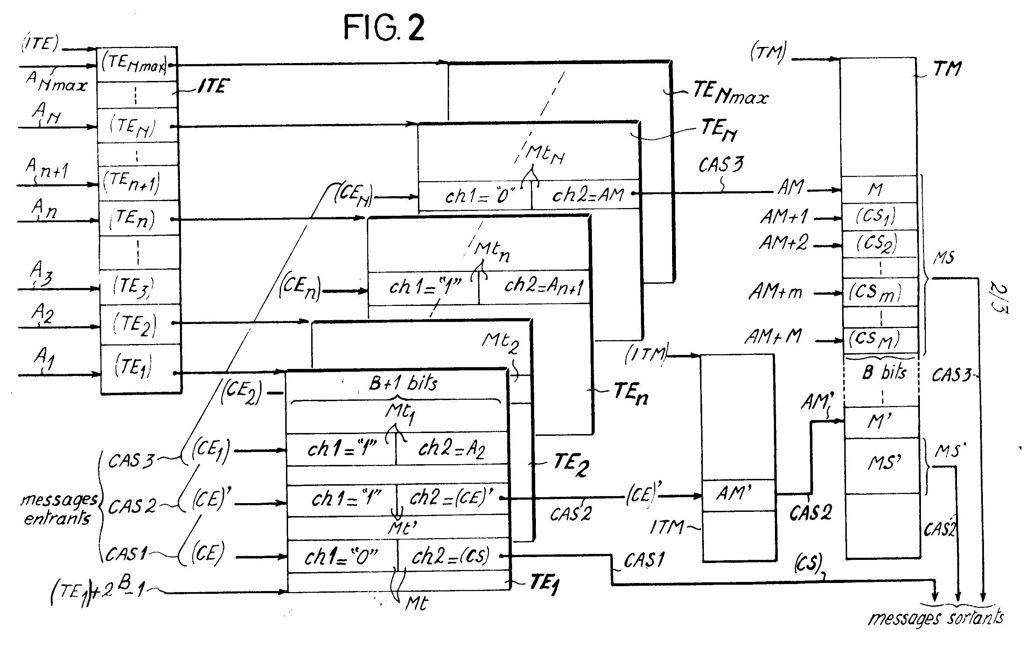

Dans les paragraphes suivants, en relation avec la Fig.2, est décrite une organisation simplifiée des tables de transcodage.

De manière générale, l'unité centrale 4 procède pour adresser les différentes tables de transcodage, suivant des modes d'adressage dits mode d'adressage relatif et mode d'adressage indexé. Le mode d'adressage relatif consiste à fournir à un processeur, un mot d'adresse représentant un décalage à réaliser généralement par rapport à la valeur d'un compteur programme afin d'obtenir une adresse effective dans une zone mémoire. Dans le mode d'adressage indexé, le mot d'adresse est fourni au processeur avec l'adresse d'un registre dit index contenant une valeur à ajouter au mot d'adresse pour obtenir une adresse effective. L'index est situé en mémoire vive et est modifiable en cours de programme, ce qui autorise une grande souplesse d'adressage. Les modes d'adressage relatif et indexé sont d'un usage fréquent pour l'adressage de tables, car ils permettant simplement de convertir une donnée en une adresse dans une table pouvant être implantée indifféremment dans une zone mémoire.

Les tables de transcodage comprennent des tables d'entrée $TE_1$ à $TE_{Nmax}$, une table de messages TM, une table index ITE pour l'adressage des tables d'entrée, et une table index ITM pour l'adressage de la table de messages.

Les tables d'entrée $TE_1$ à $TE_{Nmax}$ supportent une arborescence logique d'identification des messages entrants. Cette arborescence comprend différentes possibilités de cheminement aboutissant à l'identification de mots entrants isolés ou de suite de mots entrants connus par l'appareil de transcodage.

Chacune des tables d'entrée $TE_1$, $TE_2$,... $TE_n$, ... $TE_N$,... $TE_{Nmax}$ est localisée en mémoire vive par une adresse de début de table $(TE_1)$, $(TE_2)$,... $(TE_n)$,... $(TE_N)$,... $(TE_{Nmax})$ respectivement.

Seule la table d'entrée $TE_1$ parmi la totalité des tables d'entrée est utilisée pour le transcodage d'un mot entrant isolé (CE) ou (CE'). Le transcodage de suite de N mots entrants fait appel aux tables d'entrée $TE_1$ à $TE_N$. Les mots entrants $(CE_1)$, $(CE_2)$,... $(CE_n)$,... $(CE_N)$ adressent dans les tables d'entrée $TE_1$, $TE_2$,... $TE_n$,... $TE_N$, par rapport aux adresses de début $(TE_1)$, $(TE_2)$,... $(TE_n)$,... $(TE_N)$, des mots de transcodage $Mt_1$, $Mt_2$,... $Mt_n$,... $Mt_N$ respectivement. Les tables d'entrée $TE_2$ à $TE_{Nmax}$ ne sont utilisées que pour le transcodage des messages entrants auxquels peuvent correspondre plus d'un mot sortant, leur fonction étant différente de celle de la table d'entrée $TE_1$ elles peuvent également être appelées "tables de renvoi".

Chacune des tables d'entrée comprend autant de mots de transcodage que de mots entrants différents pouvant être délivrés par le système S1, soit $2^{B-1}$ mots de transcodage, en supposant que chaque mot entrant comprend B bits, typiquement 8 bits répartis en deux demi-octets en base numérique hexadécimale. A un mot entrant ayant la valeur notée "$00_H$" en base numérique hexadécimale correspond un caractère, noté "NUL" dans la plupart des alphabets normalisés. Le caractère NHL, bien que pouvant être traité comme tout autre caractère, est utilisé dans les tables d'entrée, ou tables de renvoi, $TE_2$ à $TE_{Nmax}$ pour prendre en compte des messages entrants de longueur supérieure.

Chacun des mots de transcodage $Mt_n$ comprend $B + 1$ bits et est divisé en des premier et second champs ch1 et ch2. Le premier champ ch1 est un indicateur d'indentification ; il est composé du bit de poids fort, dit le bit le plus significatif MSB. Le second champ ch2 est composé des B bits restants du mot de transcodage $Mt_n$. Le champ ch2 est généralement une adresse utilisée par l'unité centrale pour poursuivre le traitement de transcodage ; il peut également, dans la table d'entrée $TE_1$, être un mot sortant transcodé (CS).

La table de messages TM est localisée en mémoire vive par une adresse de début de table (TM). Dans la table TM sont mémorisés des messages sortants transcodés constitués de mots sortants ayant chacun B bits. Un message sortant transcodé MS est précédé dans la table TM par le nombre M de mots sortants contenus dans ce message. Le nombre M et les mots sortants $(CS_1)$, $(CS_2)$,... $(CS_m)$,... $(CS_M)$ d'un message MS sont respectivement mémorisés à des adresses AM et $AM + 1$, $AM + 2$, ... $AM + m$, ... $AM + M$ par rapport à l'adresse (TM).

Pour une lecture d'un message sortant MS, seule l'adresse AM est fournie à l'unité centrale ; celle-ci lit le nombre M afin de déduire l'adresse $AM + M$ de fin de message. Les mots sortants sont ensuite lus successivement à partir de l'adresse $AM + 1$ de début de message jusqu'à l'adresse AM + M de fin de message. Si le nombre M est égal à 0, aucun message sortant ne correspond au message entrant.

La table index ITE est une table intermédiaire utilisée par l'unité centrale pour adresser un mot de transcodage $Mt_n$ dans une table d'entrée $TE_n$ ; elle contient les adresses de début de table $(TE_1)$ à $(TE_{Nmax})$ des tables d'entrée $TE_1$ à $TE_{Nmax}$. La table ITE se trouve en mémoire à une adresse de début (ITE). Chacune des adresses de début de table $(TE_1)$ à $(TE_{Nmax})$ est localisée dans la table index ITE par une adresse, $A_1$ à $A_{Nmax}$ respectivement.

La table index ITM est une table intermédiaire utilisée par l'unité centrale pour adresser des messages sortants transcodés MS' dans la table de message (TM) à partir de mots de transcodage Mt' de la table d'entrée $TE_1$. La table ITM est localisée en mémoire vive par l'adresse de début (ITM).

La Fig.2 montre l'utilisation des tables de transcodage par l'unité centrale pour trois cas typiques de traitement de transcodage.

Selon un premier cas typique CAS1, à un message entrant constitué d'un unique mot entrant (CE) correspond un message transcodé composé d'un unique mot sortant transcodé (CS). Le mot entrant (CE) adresse dans la table $TE_1$, par rapport à l'adresse de début de table $(TE_1)$, un mot de transcodage Mt. Le champ ch1 du mot Mt à l'état binaire "0" indique à l'unité centrale que le second champ ch2 du mot Mt est le mot sortant transcodé (CS).

Selon un second cas typique CAS2, à un message entrant constitué d'un unique mot entrant (CE') correspond un message sortant transcodé MS' de longueur M' différente de 1. Les champs ch1 et ch2 d'un mot de transcodage Mt' sélectionné par le mot (CE') sont alors respectivement à l'état binaire "1", contrairement au cas précédent CAS1, et égal au mot entrant (CE'). L'unité centrale utilise le mot (CE') pour adresser dans la table index ITM un mot d'adresse AM'. Le mot AM' lu par l'unité centrale est, dans la table de message TM, l'adresse du message MS' correspondant au mot (CE').

Selon un troisième cas typique CAS3, à un message entrant constitué d'une suite de N mots entrants $[(CE_1), (CE_2),... (CE_n),... (CE_N)]$ correspond un message sortant transcodé MS comprenant une suite de M mots sortants $[(CS_1), (CS_2),... (CS_m),... (CS_M)]$.

Le premier mot entrant $(CE_1)$ sélectionne dans la table d'entrée $TE_1$ un mot de transcodage $Mt_1$ ayant un premier champ ch1 à l'état binaire "1". Le second champ ch2 du mot $Mt_1$ est différent du mot entrant $(CE_1)$, contrairement au cas précédent CAS 2, ce qui permet à l'unité centrale de reconnaître le mot $(CE_1)$ comme étant le premier mot d'une suite de mots connue. Le champ ch2 du mot $Mt_1$ est égal à l'adresse $A_2$ situant l'adresse de début $(TE_2)$ dans la table d'index ITE. Un second mot entrant $(CE_2)$ sélectionne alors dans la table $TE_2$, par rapport à l'adresse de début $(TE_2)$ lue dans la table index ITE, un second mot de transcodage $Mt_2$ ayant un premier champ ch1 à l'état binaire "1". Le champ ch1 du mot $Mt_2$ à l'état binaire "1" confirme le cheminement d'identification suivi et indique à l'unité centrale qu'un troisième mot entrant $(CE_3)$ est attendu. Le champ ch2 du mot $Mt_2$ est l'adresse $A_3$ situant dans la table ITE, l'adresse de début $(TE_3)$ de la table d'entrée $TE_3$.

Le mot entrant $(CE_3)$ est utilisé de manière analogue au mot $(CE_2)$ pour sélectionner dans la table d'entrée $TE_3$ un mot de transcodage $Mt_3$ dont le champ ch1 à l'état binaire "1" indique à l'unité centrale de poursuivre un même processus, jusqu'au mot entrant $(CE_N)$. Le mot entrant $(CE_N)$ sélectionne dans la table $TE_N$ un mot de transcodage $Mt_N$ dont le champ ch1 à l'état binaire "0" permet à l'unité centrale de reconnaître le mot $(CE_N)$ comme étant le dernier mot de la suite connue. Le champ ch2 égal alors à une adresse AM de la table de messages TM est lu par l'unité centrale afin d'adresser dans la table TM le message sortant transcodé MS correspondant. Le nombre M de mots du message MS mémorisé à l'adresse AM est compris entre 0 et Mmax. Pour un message MS correspondant, ayant un seul mot, le nombre M est égal à 1. Un mot unique sortant $(CS_1)$ est ainsi lu, à l'adresse AM + 1.

Un mot entrant suivant le mot $(CE_N)$ adresse à nouveau la table d'entrée $TE_1$.

Le cas CAS3 qui vient d'être décrit, concerne un cheminement dans les tables d'entrée $TE_1$ à $TE_{Nmax}$ aboutissant directement à l'identification d'une suite de mots entrants comme étant un message entrant à transcoder connu par l'unité centrale. Toutefois après un mot entrant $(CE_n)$ identifié comme le $n^{ième}$ mot entrant d'une suite de mots connue, peut se présenter un mot entrant $(CE_{n+1})$ qui n'est pas le $(n+1)^{ième}$ mot attendu de la suite de mots entrants connue. Le mot entrant $(CE_{n+1})$ adresse alors dans la table d'entrée $TE_{n+1}$ un mot de transcodage $Mt_{n+1}$ ayant une valeur déterminée, par exemple "$00_H$".

La valeur "$00_H$" ainsi déterminée est pour l'unité centrale un code d'échec lui indiquant, compte tenu du dernier mot entrant $(CE_{n+1})$, soit un échec dans le transcodage soit l'existence d'un message connu de longueur supérieure. L'unité centrale initialise alors les mots de transcodage $Mt_1$ à $Mt_{n+1}$ avec de nouvelles valeurs contenues dans une table associée aux tables d'entrée. Un nouvel essai de transcodage est entrepris à partir des mots entrants $(CE_1)$ à $(CE_{n+1})$ préalablement sauvegar-

dés dans une table de mots entrants. La table associée aux tables d'entrée contient les différents mots de transcodage possibles à une même adresse dans une table d'entrée ; ces différents mots correspondent à différentes possibilités de cheminements. Différentes possibilités de cheminement peuvent être essayées par l'unité centrale avant d'aboutir au transcodage des mots $(CE_1)$ à $(CE_p)$, où p est un entier supérieur ou égal à 1, par un ou des messages sortants transcodés.

D'autres organisations des tables de transcodage sont possibles de manière à adapter un transcodage à réaliser à des possibilités d'adressage de l'unité centrale forcément limitées et pour autoriser une grande souplesse dans le choix des valeurs affectées à des mots d'adresse, par rapport aux différentes valeurs possibles des mots entrants.

La taille des tables d'entrée $TE_2$ à $TE_{Nmax}$ décrites précédemment peut être sensiblement réduite par l'utilisation de tables d'index.

En effet, un mot entrant $(CE_p)$ adressant une table d'entrée $TE_p$, où p est un entier compris entre 2 et Nmax, et identifié avec succès, c'est-à-dire identifié comme étant bien le $p^{ième}$ mot entrant de la suite de mot attendu, est généralement compris entre un mot entrant minimum $(CE_p)_{mini}$ et un mot entrant maximum $(CE_p)_{maxi}$ conduisant à des succès dans l'identification par la table $TE_p$. Un table d'index $ITE_p$ associée à la table $TE_p$ contenant les mots $(CE_p)_{mini}$ et $(CE_p)_{maxi}$ et utilisée pour l'adressage de la table $TE_p$ permet de limiter la taille de la table d'entrée $TE_p$ au nombre de mots compris entre $(CE_p)_{mini}$ et $(CE_p)_{maxi}$.

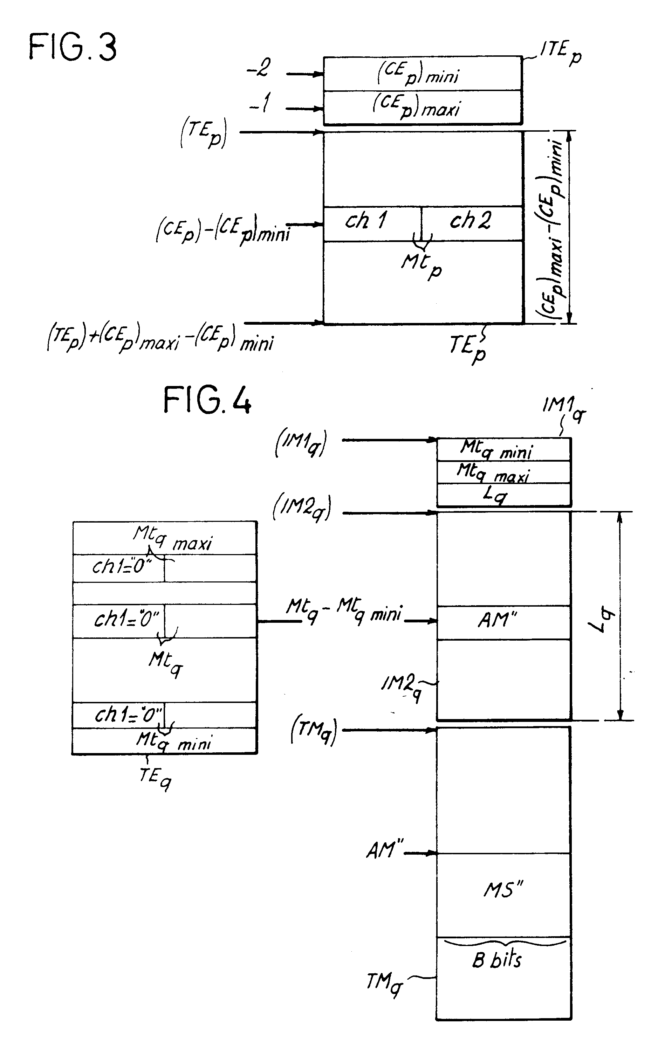

Comme montré à la Fig.3, la position de la table d'index $ITE_p$ associée à la table $TE_p$ est de préférence contiguë à la table $TE_p$ et prédède celle-ci dans la zone mémoire RAM de l'appareil. Les mots $(CE_p)_{mini}$ et $(CE_p)_{maxi}$ sont ainsi adressés en effectuant respectivement un décalage de -2 et -1 par rapport à l'adresse de début de table $(TE_p)$ de la table $TE_p$.

Un mot entrant $(CE_p)$ lu par l'unité centrale est d'abord comparé aux mots $(CE_p)_{mini}$ et $(CE_p)_{maxi}$. Si le mot entrant $(CE_p)$ n'est pas compris dans la fourchette définie par les mots $(CE_p)_{mini}$ et $(CE_p)_{maxi}$, l'unité centrale en déduit directement un échec de l'essai de transcodage en cours. Si le mot entrant $(CE_p)$ est bien compris entre les mots $(CE_p)_{mini}$ et $(CE_p)_{maxi}$, le mot de transcodage $MT_p$ correspondant est adressé dans la table d'entrée $TE_p$ à partir de l'adresse de début $(TE_p)$ par le mot $(CE_p)-(CE_p)_{mini}$ représentant la différence numérique entre les mots $(CE_p)$ et $(CE_p)_{mini}$.

La table de message TM peut être remplacée par Nmax tables de messages $TM_1$ à $TM_{Nmax}$ respectivement associées aux tables d'entrée $TE_1$ à $TE_{Nmax}$.

En référence à la Fig.4, une table d'entrée $TE_q$, où q est un entier compris entre 1 et Nmax, adresse dans la table de message $TM_q$ qui lui est associée, un message sortant MS" à l'aide de tables d'index respectives, $IM1_q$ et $IM2_q$.

La table d'index $IM1_q$ est localisée par son adresse de début $(IM1_q)$ et est composée de 3 mots de B bits, $Mt_{qmini}$, $Mt_{qmaxi}$, et $L_q$. Le mot $Mt_{qmini}$ est placé à l'adresse de début de table $(IM1_q)$ et est égal à un mot de transcodage minimum de la table d'entrée $TE_q$ ayant un indicateur ch1 = "0" et auquel correspond un message sortant dans la table de messages $TM_q$. Le mot $Mt_{qmaxi}$ est placé à l'adresse suivante $(IM1_q)+1$ et est égal à un mot de transcodage maximum de la table d'entrée $TE_q$ ayant un indicateur ch1 = "0' et auquel correspond un message sortant dans la table de messages $TM_q$ ; il est essentiellement utilisé pendant la phase de génération et d'initialisation des tables pour des vérifications ou des modifications de tables.

La table d'index $IM2_q$ comprend $L_q$ mots de B bits. Chacun des mots de la table d'index $IM2_q$ est une adresse d'un message sortant dans la table de messages correspondante $TM_q$, par rapport à une adresse de début $(TM_q)$ de la table de messages.

Une table de messages $TM_q$ est localisée par l'adresse de début de table $(TM_q)$. Un message sortant MS" de la table de message est adressé dans la table de messages $TM_q$ par un mot d'adresse AM" mémorisé dans la table index $IM2_q$.

Un mot de transcodage $MT_q$ de la table d'entrée $TE_q$ auquel correspond un message sortant MS" est compris entre les mots $Mt_{qmini}$ et $Mt_{qmaxi}$. L'unité centrale après avoir vérifié que le mot $Mt_q$ est bien compris entre les mots $Mt_{qmini}$ et $Mt_{qmaxi}$, lit le mot d'adresse AM" dans la table d'index $IM2_q$ en l'adressant à partir de l'adresse de début $(IM2_q)$ par la différence numérique des mots $Mt_q$ et $Mt_{qmini}$, soit $Mt_q-Mt_{qmini}$.

De préférence les tables $IM1_q$, $IM2_q$, et $TM_q$, sont contiguës dans la zone mémoire RAM de l'appareil, comme montré à la Fig.4. En effet, l'unité centrale peut alors déduire les adresses de débuts de tables $(IM2_q)$ et $(TM_q)$ à partir de l'adresse $(IM1_q)$, de la taille invariable de la table $IM1_q$ fixée à 3 mots, et du mot $L_q$ représentant la taille de la table $IM2_q$, et réduit de ce fait le nombre d'opération de lecture nécessaire pour l'adressage des messages sortants.

L'appareil de transcodage selon l'invention peut subir diverses modifications pour l'adapter à différents modes de fonctionnement ou pour minimiser son coût. L'unité de gestion d'échange 3, dans la réalisation qui vient d'être décrite, peut être réalisée en logique câblée à l'aide de décodeurs, bascules et portes logiques, ou incluse dans l'unité centrale assurant la gestion d'échange à partir d'un microprogramme contenu en mémoire morte. Dans une réalisation plus perfectionnée, notamment pour un appareil de transcodage bidirectionnel, l'unité de gestion d'échange peut être réalisée à l'aide d'un microcontrôleur à microprocesseur, esclave de l'unité centrale et gérant les communications de manière autonome.

Pour certaines réalisations ne nécessitant qu'une zone de mémoire réduite pour le traitement de transcodage, l'unité centrale peut contenir, en mémoire morte, un logiciel de génération des tables de transcodage. Le micro-ordinateur 6 peut alors être remplacé par un simple terminal de dialogue, ou un clavier hexadécimal muni d'afficheurs, pour introduire dans l'appareil de transcodage différents paramètres et données à saisir relatifs aux systèmes S1 et S2 et au mode de fonctionnement désiré.

De plus, si aucun moyen pour visualiser et surveiller des opérations de transcodage en cours n'est nécessaire, le terminal ou le micro-ordinateur 6 peut n'être connecté à l'appareil de transcodage que pendant la phase d'initialisation préalable, la connexion du terminal à l'appareil pouvant alors être effectuée par l'intermédiaire de l'interface 1 ou 2.

**Revendications**

1. Procédé pour transcoder des messages entrants de différentes longueurs en des messages sortants transcodés de différentes longueurs, un message entrant quelconque étant composé de N mots binaires entrants, N étant un entier variable supérieur ou égal à 1 représentant la longueur du message entrant, et un message sortant transcodé étant composé de M mots binaires sortants, M étant un entier variable supérieur ou égal à 0 représentant la longueur du message sortant transcodé, caractérisé en ce que chaque mot binaire entrant d'un message entrant est utilisé pour adresser un mot de transcodage dans une table de transcodage correspondante associée à un rang n du mot binaire entrant dans le message entrant, où n est un entier compris entre 1 et N représentatif de son ordre chronologique d'arrivée par rapport au premier mot reconnu de la suite entrante, ledit mot de transcodage comprenant un premier champ et un second champ, en ce que dans la table de transcodage associée au rang n égal à 1, ledit premier champ est un indicateur pour identifier ledit second champ comme étant un message sortant transcodé de longueur M égale à 1 correspondant à un message entrant de longueur N égale à 1, ou comme étant une adresse dans une table de messages transcodés relative à un message sortant transcodé de longueur M différente de 1 correspondant à un message entrant de longueur N égale à 1, ou comme étant une adresse de la table de transcodage associée au rang n égal à 2, et en ce que dans les tables de transcodage associées respectivement à des rangs n différents de 1, ledit premier champ est un indicateur pour identifier ledit second champ comme étant une adresse dans ladite table de messages transcodés relative à un message sortant transcodé correspondant à un message entrant de longueur N supérieure à 1, ou comme étant une adresse de la table de transcodage associée au rang n = 1, ou comme étant un code d'échec lorsque le message entrant n'est pas à transcoder.

2. Procédé de transcodage conforme à la revendication 1, caractérisé en ce que ladite table de messages transcodés est divisée en autant de tables de messages transcodés que de tables de transcodage associées, les tables de messages transcodés étant respectivement associées aux tables de transcodage.

3. Procédé de transcodage conforme à la revendication 1 ou 2, pour des mots binaires entrants comprenant un nombre entier déterminé de bit B, caractérisé en ce que lesdites tables de transcodage comprennent au plus $2^{B-1}$ mots binaires de transcodage ayant chacun au moins B + 1 bits.

4. Appareil de transcodage pour la mise en oeuvre du procédé conforme à l'une quelconque des revendications 1 à 3, caractérisé en ce qu'il comprend :

des premier et second moyens d'interfaçage (1, 2) pour relier l'appareil à des premier et second systèmes numériques incompatibles ayant à communiquer entre eux (S1, S2), à travers des liaisons (111, 211) par lesquelles transitent les messages entrants et les messages sortants transcodés,

des moyens de traitement (4) comprenant les tables de transcodage (TE, TM, ITE, ITM) et un algorithme programmé pour identifier les messages entrants et pour délivrer consécutivement les messages sortants transcodés correspondants,

des moyens de commutation (5) pour connecter alternativement les premier et second moyens d'interfaçage (1, 2) aux moyens de traitement (4) afin que les moyens de traitement (4) reçoivent les messages entrants délivrés par les moyens d'interfaçage (1, 2) et transmettent en réponse les messages sortants transcodés correspondants aux moyens d'interfaçage (1, 2), et

des moyens de gestion d'échange (3) pour gérer les moyens d'interfaçage (1, 2) et les moyens de commutation (5) en fonction d'un mot binaire de commande délivré par les moyens de traitement (4) et pour réguler le débit des messages échangés entre l'appareil et lesdits systèmes (S1, S2) en fonction d'informations fournies par les moyens d'interfaçage (1, 2).

5. Appareil de transcodage conforme à la revendication 4, caractérisé en ce que les premier et second moyens d'interfaçage (1, 2) comprennent chacun des moyens (11, 21) pour adapter l'appareil auxdites liaisons (111, 211), de type parallèle et/ou de type série, et des moyens (12, 22) pour stocker en file d'attente les messages entrants et les messages sortants transcodés.

6. Appareil de transcodage conforme à la revendication 5, caractérisé en ce que les moyens de gestion d'échange (3) définissent des seuils de remplissage hauts et bas des moyens pour stocker (12, 22) et gèrent le remplissage des moyens pour stocker (12, 22) en fonction d'un cycle d'hystérésis défini à partir desdits seuils.

7. Appareil de transcodage conforme à l'une quelconque des revendications 4 à 6, caractérisé en ce que les moyens de traitement (4) comprennent une mémoire vive (43) pour tables de transcodage et une mémoire morte d'algorithme (42).

8. Appareil programmable de transcodage conforme à la revendication 7, caractérisé en ce que des moyens (6) sont prévus pour initialiser les moyens de traitement (4) lors d'une phase préalable au transcodage, par le chargement dans ladite mémoire vive (43) desdites tables de transcodage (TE) et d'autres tables dont la ou les tables de messages transcodés (TM).

9. Appareil programmable de transcodage conforme à la revendication 8, caractérisé en ce que lesdits moyens pour initialiser (6) visualisent des données en cours de transcodage.

10. Appareil programmable de transcodage conforme à l'une quelconque des revendications 8 à 9, caractérisé en ce que les moyens pour initialiser (6) sont un micro-ordinateur, un terminal, ou un clavier hexadécimal comprenant des afficheurs.

**Claims**

1. Method for transcoding incoming messages having different lengths into transcoded outgoing messages having different lengths, an any incoming message being composed of N incoming binary words, N being a variable integer greater than or equal to 1 and representing the length of the incoming message, and a transcoded outgoing message being composed of M outgoing binary words, M being a variable integer greater than or equal to 0 and representing the length of the transcoded outgoing message, characterized in that each incoming binary word of an incoming message is used to address a transcoding word in a corresponding transcoding table associated to a rank n of the incoming binary word in the incoming message, where n is an integer comprised between 1 and N and representative of its chronological arrival order in relation to the first recognized word of the incoming sequence, said transcoding word comprising a first field and a second field, in that in the transcoding table associated to the rank n equal to 1, said first field is an indicator for identifying said second field as being a transcoded outgoing message having a length M equal to 1 corresponding to an incoming message having a length N equal to 1, or as being an address in a table of transcoded messages relative to a transcoded outgoing message having a length M different from 1 corresponding to an incoming message having a length N equal to 1, or as being an address of the transcoding table associated to the rank n equal to 2, and in that in the transcoding tables associated respectively to ranks n different from 1, said first field is an indicator for identifying said second field as being an address in said table of transcoded messages relative to a transcoded outgoing message corresponding to an incoming message having a length N greater than 1, or as being an address of the transcoding table associated to rank n + 1, or as being a failure code when the incoming message is not to be transcoded.

2. Transcoding method according to claim 1, characterized in that said table of transcoded messages is divided into as many transcoded message tables as associated transcoding tables, the transcoded message tables being respectively associated to the transcoding tables.

3. Transcoding method according to claim 1 or 2, for incoming binary words comprising a determined integer number of bits B, characterized in that said transcoding tables comprise at the most $2^{B-1}$ transcoding binary words, each having at least B + 1 bits.

4. Transcoding device for carrying out the method according to any one of claims 1 to 3, characterized in that it comprises :

first and second interfacing means (1, 2) for connecting the device to first and second incompatible digital systems having to communicate together (S1, S2), via links (111, 211) through which the incoming messages and transcoded outgoing messages transit,

processing means (4) comprising the transcoding tables (TE, TM, ITE, ITM) and a programmed algorithm for identifying the incoming messages and for delivering consecutively the transcoded corresponding outgoing messages,

switching means (5) for connecting alternatly the first and second interfacing means (1, 2) to the processing means (4) whereby the processing means (4) receive the incoming messages delivered from the interfacing means (1, 2) and transmit in response the corresponding transcoded outgoing messages to the interfacing means (1, 2), and

exchange management means (3) for managing the interfacing means (1, 2) and the switching means (5) in terms of a control binary word delivered from the processing means (4) and for regulating the rate of messages exchanged between the device and said systems (S1, S2) in terms of data supplied by the interfacing means (1, 2).

5. Transcoding device according to claim 4, characterized in that the first and second interfacing means (1, 2) each comprise means (11, 21) for adapting the device to said links (111, 211), of parallel type and/or series type, and means (12, 22) for storing in queue file the incoming messages and the transcoded outgoing messages.

6. Transcoding device according to claim 5, characterized in that the exchange management means (3) define upper and lower filling limits for storing means (12, 22) and manage the filling in the storing means (12, 22) depending on a hysteresis cycle defined from said limits.

7. Transcoding device according to any one of claims 4 to 6 characterized in that the processing means (4) comprise a random access memory (43) for transcoding tables and an algorithm read only memory (42).

8. Transcoding programmable device according to claim 7, characterized in that means (6) are provided for initializing the processing means (4) during a phase prior to transcoding, by loading said transcoding tables (TE) and of other tables such as one or several tables of transcoded messages (TM) into said random access memory (43).

9. Programmable transcoding device according to claim 8, characterized in that said initializing means (6) display data during transcoding.

10. Programmable transcoding device according to any one of claims 8 to 9, characterized in that the initializing means (6) are a microcomputer, a terminal, or an hexadecimal keyboard comprising display units.

**Patentansprüche**

1. Verfahren zur Umcodierung von eingehenden Nachrichten verschiedener Längen in umcodierte ausgehende Nachrichten verschiedener Längen, wobei eine beliebige eingehende Nachricht aus N eingehenden Binärworten besteht, wobei N eine veränderliche ganze Zahl größer oder gleich 1, darstellend die Länge der eingehenden Nachricht ist, und wobei eine umcodierte ausgehende Nachricht aus M ausgehenden Binärworten besteht, wobei M eine veränderliche ganze Zahl größer oder gleich 0 ist, darstellend die Länge der ausgehenden umcodierten Nachricht, dadurch **gekennzeichnet,** daß jedes eingehende Binärwort einer eingehenden Nachricht verwendet wird, um ein Umcodierungswort in einer entsprechenden Umcodierungstabelle zu adressieren, die einem Rang n des eingehenden Binärwortes in der eingehenden Nachricht zugeordnet ist, wo n eine ganze Zahl ist, enthalten zwischen 1 und N, repräsentativ in ihrer chronologischen Zugangsreihenfolge in bezug auf das erste erkannte Wort der eingehenden Folge, wobei das Umcodierungswort ein erstes Feld und ein zweites Feld aufweist, daß in der dem Rang n gleich 1 zugeordneten Umcodierungstabelle das erste Feld eine Hinweisbezeichnung zur Identifizierung des zweiten Feldes ist, als ob es eine umgeschriebene ausgehende Nachricht mit der Länge M gleich 1 entsprechend einer eingehenden Nachricht mit der Länge N gleich 1 ist oder als ob es eine Adresse in einer Tabelle von umcodierten Nachrichten bezüglich einer umcodierten ausgehenden Nachricht mit der Länge M verschieden von 1 entsprechend einer eingehenden Nachricht mit der Länge N gleich 1 ist oder als ob es eine Adresse der dem Rang n gleich 2 zugeordneten Umcodierungstabelle ist, und daß in den jeweils zugeordneten Umcodierungstabellen mit Rängen n verschieden von 1 das erste Feld eine Hinweisanzeige zur Identifizierung des zweiten Feldes ist, als ob es eine Adresse in der Tabelle von umcodierten Nachrichten, sich beziehend auf eine umcodierte ausgehende Nachricht entsprechend einer eingehenden Nachricht mit der Länge N größer als 1 ist oder als ob es eine Adresse der dem Rang n + 1 zugeordneten Umcodierungstabelle ist oder als ob es ein Abbruchcode ist, wenn die eingehende Nachricht nicht umzucodieren ist.

2. Umcodierungsverfahren nach Anspruch 1, dadurch **gekennzeichnet,** daß die Tabelle von umcodierten Nachrichten in soviele Tabellen von umcodierten Nachrichten wie zugeordnete Umcodierungstabellen unterteilt ist, wobei die Tabellen von umcodierten Nachrichten jeweils den Umcodierungstabellen zugeordnet sind.

3. Umcodierungsverfahren nach Anspruch 1 oder 2, für eingehende Binärwörter, aufweisend eine bestimmte ganzzahlige Anzahl von Bits B, dadurch **gekennzeichnet,** daß die Umcodierungstabellen höchstens $2^{B-1}$ binäre Umcodierungswörter umfassen, die jeweils wenigstens B + 1 Bits aufweisen.

4. Umcodierungsvorrichtung zur Durchführung des Verfahrens nach einem beliebigen der Ansprüche 1 bis 3, dadurch **gekennzeichnet,** daß sie umfaßt:
   - erste und zweite Interfacemittel (1, 2) zum Verbinden der Vorrichtung mit ersten und zweiten inkompatiblen numerischen Systemen (S1, S2), die miteinander kommunizieren sollen, über Verbindungen (111, 211), die die eingehenden Nachrichten und die umcodierten ausgehenden Nachrichten durchlaufen,
   - Verarbeitungsmittel (4), umfassend Umcodierungstabellen (TE, TM, ITE, ITM) und einen programmierten Algorithmus zum Identifizieren der eingehenden Nachrichten und zum aufeinanderfolgenden Ausgeben der entsprechenden umcodierten ausgehenden Nachrichten,
   - Umschaltmittel (5) zum wechselweisen Verbinden der ersten und zweiten Interfacemittel (1, 2) mit den Verarbeitungsmitteln (4), damit die Verarbeitungsmittel (4) die durch die Interfacemittel (1, 2) ausgegebenen eingehenden Nachrichten aufnehmen und in Reaktion die umcodierten, den Interfacemitteln (1, 2) entsprechenden ausgehenden Nachrichten übertragen, und
   - Austauschsteuerungsmittel (3) zum Leiten der Interfacemittel (1, 2) und der Umschaltmittel (5), abhängig von einem von den Verarbeitungsmitteln (4) ausgegebenen binären Steuerwort, und zum Regulieren des Durchsatzes der zwischen der Vorrichtung und den Systemen (S1, S2) ausgetauschten Nachrichten, abhängig von durch die Interfacemittel (1, 2) gelieferten Informationen.

5. Umcodierungsvorrichtung nach Anspruch 4, dadurch **gekennzeichnet,** daß die ersten und zweiten Interfacemittel (1, 2) jeweils Mittel (11, 21) zum Anpassen der Vorrichtung an die Verbindungen (111, 211) vom parallelen Typ und/oder vom seriellen Typ, und Mittel (12, 22) zum Speichern der eingehenden Nachrichten und der umcodierten ausgehenden Nachrichten in der Warteschlange umfassen.

6. Umcodierungsvorrichtung nach Anspruch 5, dadurch **gekennzeichnet,** daß die Austauschsteuerungsmittel (3) obere und untere Auffüllschwellen zum Speichern (12, 22) festlegen und das Auffüllen der Mittel zum Speichern (12, 22) abhängig von einem ausgehend von den Schwellwerten definierten Hysteresezyklus leiten.

7. Umcodierungsvorrichtung nach einem beliebigen der Ansprüche 4 bis 6, dadurch **gekennzeichnet,** daß die Verarbeitungsmittel (4) einen schnellen Speicher (43) für Umcodierungstabellen und einen Algorithmus-Festspeicher (42) umfassen.

8. Programmierbare Umcodierungsvorrichtung nach Anspruch 7, dadurch **gekennzeichnet,** daß die Mittel (6) vorgesehen sind, um die Verarbeitungsmittel (4) zur Zeit einer vorläufigen Umcodierungsphase durch das Laden der Umcodierungstabellen (TE) und anderer Tabellen von der oder den Tabellen von umcodierten Nachrichten (TM) in den schnellen Speicher (43) zu initialisieren.

9. Programmierbare Umcodierungsvorrichtung nach Anspruch 8, dadurch **gekennzeichnet,** daß die Mittel zum Initialisieren (6) Daten im Verlauf der Umcodierung sichtbar machen.

10. Programmierbare Umcodierungsvorrichtung nach einem beliebigen der Ansprüche 8 bis 9, dadurch **gekennzeichnet,** daß die Mittel zum Initialisieren (6) ein Mikrorechner, ein Terminal oder eine hexadezimale Tastatur, umfassend Anzeigeeinrichtungen sind.

# FIG.1

FIG. 2

## FIG.3

## FIG.4